# EUROPEAN PATENT APPLICATION

(11) **EP 4 661 074 A2**
(43) Date of publication of application: **10.12.2025**
(21) Application number: 25179787.4
(22) Date of filing: 30.05.2025
(51) Int. Cl.: H01L 23/00

(54) **SEMICONDUCTOR APPARATUS, MANUFACTURING METHODS, AND ELECTRICAL SYSTEMS**

(30) Priority: 03.06.2024 CN 202410712120; 21.05.2025 US 202519214562
(71) Applicant: Shenzhen STS Microelectronics Co., Ltd., Shenzhen 518048 (CN); STMicroelectronics International N.V., 1228 Plan-les-Ouates, Geneva (CH)
(72) Inventor: CHEN, Qiao, SHENZHEN, 518040 (CN); ZHENG, Nan Nan, SHENZHEN, 518038 (CN); SHI, Xiao Lei, SHENZHEN, 518038 (CN); QUATTROCCHIO, Matteo Luca, 28100 NOVARA (IT); LIANG, Hao Ting, SHENZHEN, 518040 (CN)
(74) Representative: Casalonga

(57) **Abstract**

The present disclosure relates to a semiconductor device, a manufacturing method thereof, and an electrical system. An example semiconductor comprises: a semiconductor substrate comprising at least one power semiconductor device; an insulating film on the semiconductor substrate having at least one first opening that penetrates through the insulating film, the at least one first opening exposing a corresponding first portion of the semiconductor substrate; at least one conductive attachment component filled in a corresponding first opening of the at least one first opening; and a metal sheet provided on the insulating film and the at least one attachment component, wherein a corresponding portion of the metal sheet is bonded and electrically connected to the corresponding first portion of the semiconductor substrate by the at least one attachment component.

## Description

### Background

The Die Top System (DTS) is getting more and more attentions. DTS provides a thick metal sheet (such as a copper foil) on top of a die to increase the strength of the top surface of the die, thereby achieving a thick interconnection solution.

The inventors of the present application have found that there are some shortcomings in the related products and processes, such as high production costs, complex processes, high storage requirements, inherent material defects, and low device yield (e.g., low units per hour (UPH)).

Existing DTS technology is a die-level solution. In a typical existing DTS scheme, a sintering paste is first applied to a mounting substrate (e.g. a copper-applied substrate) and pre-dried. A die is then picked up and placed in an appropriate position on the mounting substrate with the sintering paste sandwiched between. Sintering process is then performed to bond the die and mounting substrate using the sintering paste. In addition, a sintering paste is pre-coated on a surface of a prefabricated half-cut copper sheet opposite to the chip (die). This pre-coating process requires a solid tacking agent to help the sintering paste hold its shape during processing or to provide a temporary bond prior to the final formation of an attachment material from the sintering paste. Next, the sintering paste is pre-dried and the tacking agent is thermally activated (to activate the tacking agent in the sintering paste). A copper sheet unit is then picked up from the half-cut copper sheet and placed on a side of the die opposite to the mounting substrate. Then, pressure sintering is performed to bond the copper sheet to the die. Wires or strips can then be bonded to the copper sheet and molding is performed.

The existing DTS scheme requires two sintering steps and two pick-and-place steps, as well as a tacking agent and its activation. This makes the process complex and makes the yield low.

On the other hand, the pre-coated sintering paste is unstable, and pre-dried paste particles may fall off during the pick-and-place process. In addition, during the sintering process, the tacking agent may evaporate and disappear, thereby resulting in large voids. If a liquid phase tacking agent is used, the UPH may be further reduced. In addition, the device manufactured in this way may be sensitive to temperature, humidity, and vacuum level, and therefore has high storage requirements. Furthermore, the thickness of the metal sheet used in the existing DTS scheme is fixed, which limits design flexibility.

Therefore, there is a need for an improved semiconductor apparatus and its manufacturing method in the related field.

### Brief Summary

In view of the above problems, the present disclosure herein is proposed to solve at least one or more of the above problems.

According to one aspect of the present disclosure, there is provided a semiconductor apparatus, comprising: a semiconductor substrate comprising at least one power semiconductor device; an insulating film on the semiconductor substrate, the insulating film having at least one first opening that penetrates through the insulating film, the at least one first opening exposing a corresponding first portion of the semiconductor substrate; at least one conductive attachment component filled in a corresponding first opening of the at least one first opening; and a metal sheet provided on the insulating film and the at least one attachment component, wherein a corresponding portion of the metal sheet is bonded and electrically connected to the corresponding first portion of the semiconductor substrate by the at least one attachment component.

In some embodiments, the insulating film further comprises at least one second opening that exposes a corresponding second portion of the semiconductor substrate, wherein the metal sheet does not overlap with the at least one second opening.

In some embodiments, the at least one first opening exposes at least a portion of a corresponding current terminal of a corresponding semiconductor device, and the at least one second opening exposes at least a portion of a control terminal of the corresponding semiconductor device.

In some embodiments, the semiconductor substrate comprises a wafer, wherein the at least one power semiconductor device comprises a plurality of power semiconductor devices arranged in an array, and the insulating film comprises a plurality of first openings each exposing a metallization layer of a corresponding one of the plurality of power semiconductor devices.

In some embodiments, the semiconductor substrate comprises a die separated from a wafer, wherein the insulating film and the metal sheet are substantially not present on lateral side faces of the semiconductor substrate, and wherein at least one side face of the insulating film, a corresponding side face of the metal sheet and a corresponding side face of the semiconductor substrate are substantially flush with each other.

In some embodiments, the insulating film is formed of organic material, and wherein the metal sheet comprises one or more layers of metal material.

In some embodiments, the attachment component is obtained by performing a bonding process on an applied attachment material, wherein the bonding process comprises at least one of sintering, baking, annealing, transient liquid phase welding, or curing.

In one embodiment, the attachment material comprises one of the following: a sintering paste, a pre-sintering sheet, a solder, a transient liquid phase soldering material, and a conductive adhesive.

In some embodiments, the semiconductor device is a power MOS transistor, the at least one first opening exposing at least a portion of a corresponding source or drain terminal of the corresponding semiconductor device, respectively, and the at least one second opening exposing at least a portion of a gate terminal of the corresponding semiconductor device.

In some embodiments, the semiconductor apparatus further comprises: at least one first wire coupled to a corresponding current terminal of the corresponding semiconductor device; and at least one second wire coupled to a corresponding control terminal of the corresponding semiconductor device.

In some embodiments, the semiconductor apparatus further comprises: a mounting substrate comprising a die attachment portion and a lead, wherein the semiconductor substrate is attached to the die attachment portion and the at least one first wire is coupled to the lead, and wherein the at least one first wire comprises a copper wire.

According to one aspect of this disclosure, there is further provided an electrical system that comprises the semiconductor apparatus according to any embodiment of the present disclosure.

According to another aspect of the present disclosure, there is further provided a method for manufacturing a semiconductor apparatus, comprising: providing an attachment structure comprising: an insulating film having at least one first opening penetrating through the insulating film, the at least one first opening exposing a corresponding first portion of a semiconductor substrate; a metal sheet attached to the insulating film, the metal sheet comprising a portion overlapping with the at least one first opening of the insulating film; and an attachment material filled in a corresponding first opening of the at least one first opening and in contact with the metal sheet, the attachment material comprising a conductive material; attaching the attachment structure to a semiconductor wafer including at least one semiconductor device, such that the insulating film is in contact with the semiconductor wafer, the at least one first opening is aligned with a corresponding first portion of the semiconductor substrate, and the attachment material is in contact with the corresponding first portion of the semiconductor substrate; and performing a bonding process to form an attachment component from the attachment material to bond and electrically couple a corresponding portion of the metal sheet to a corresponding first portion of the semiconductor substrate through the attachment component.

In some embodiments, providing an attachment structure comprises: attaching the metal sheet to a first surface of the insulating film; filling the at least one first opening of the insulating film with the attachment material from a side of a second surface opposite to the first surface of the insulating film, the attachment material filled in the at least one first opening being in contact with the metal sheet.

In some embodiments, the method further comprises: conducting a cutting process, after the bonding process is performed, to form a separated semiconductor device.

In some embodiments, the insulating film further comprises at least one second opening that exposes a corresponding second portion of the semiconductor substrate, and wherein the metal sheet does not overlap with the at least one second opening.

In some embodiments, the insulating film and the metal sheet are substantially not present on lateral side faces of the semiconductor substrate of the semiconductor device, and wherein at least one side face of a portion of the insulating film included in the separated semiconductor device, a corresponding side face of a portion of the metal sheet included in the separated semiconductor device and a corresponding side face of the semiconductor substrate included in the separated semiconductor device are substantially flush with each other.

In some embodiments, the at least one semiconductor device comprises a power semiconductor device, the at least one first opening exposing at least a portion of a corresponding current terminal of the corresponding semiconductor device, and the at least one second opening exposing at least a portion of a control terminal of the corresponding semiconductor device.

In some embodiments, the insulating film is formed of organic material, and wherein the metal sheet comprises one or more layers of metal material..

In one embodiment, the bonding process comprises at least one of sintering, baking, annealing, transient liquid phase welding, and/or curing.

In one embodiment, the attachment material comprises one of a sintering paste, a pre-sintering sheet, a solder, a transient liquid phase soldering material, or a conductive adhesive.

In some embodiments, the method further comprises: picking up the separated semiconductor device and placing it on a mounting substrate; attaching the separated semiconductor device to the mounting substrate; bonding at least one first wire to a corresponding current terminal of the corresponding semiconductor device; and bonding at least one second wire to a corresponding control terminal of the corresponding semiconductor device.

According to the aspects and embodiments of the present disclosure, device processability and UPH are improved. Also, the requirements for harsh storage conditions can be eliminated or mitigated, significantly reducing shipping costs. In addition, according to the aspects and embodiments of the present disclosure, there is no need to use a solid tacking agent, thereby greatly reducing or avoiding the defects caused from the solid tacking agent, and improving the reliability and service life of the device.

Other features and advantages of the present disclosure will become apparent from the following detailed description of exemplary embodiments of the present disclosure with reference to the accompanying drawings.

### Brief Description of the Drawings

The accompanying drawings, which are incorporated in and constitute a portion of this specification, illustrate embodiments of the present disclosure and, together with the description, serve to explain the principles of the present disclosure.

The present disclosure will be more clearly understood from the following detailed description with reference to the accompanying drawings, in which:
FIG. 1 shows a schematic top view of a device according to some embodiments of the present disclosure;
FIG. 2 shows a schematic sectional view of the device shown in FIG. 1;
FIG. 3A shows a schematic top view of an insulating film of the device according to some embodiments of the present disclosure;
FIG. 3B shows a schematic top view of a portion of the device according to some embodiments of the present disclosure;
FIG. 3C shows a schematic top view of a portion of the device according to some embodiments of the present disclosure;
FIG. 3D shows a schematic top view of a portion of the device according to some embodiments of the present disclosure;
FIG. 4 shows a schematic perspective view of the device in its manufacturing process according to some embodiments of the present disclosure;
FIG. 5A shows a schematic top view of an insulating film according to some embodiments of the present disclosure, and FIG. 5B shows an enlarged view of a portion of the insulating film;
FIG. 6 shows a schematic top view of an insulating film according to some embodiments of the present disclosure;
FIGS. 7A and 7B show schematic sectional views of an insulating film according to other embodiments of the present disclosure;
FIG. 8 shows a schematic top view of a metal sheet according to some embodiments of the present disclosure;
FIG. 9 shows a schematic top view illustrating a metal sheet attached to an insulating film according to some embodiments of the present disclosure;
FIG. 10 shows a schematic top view illustrating a metal sheet attached to an insulating film, viewed from a side of the insulating film away from the metal sheet, according to some embodiments of the present disclosure;
FIG. 11A shows a schematic top view illustrating a metal sheet attached to an insulating film, viewed from a side of the insulating film away from the metal sheet, according to some embodiments of the present disclosure;
FIG. 11B shows a schematic top view illustrating a metal sheet attached to an insulating film, viewed from a side of the insulating film away from the metal sheet, according to other embodiments of the present disclosure;
FIG. 12 shows a schematic top view illustrating an attachment structure attached to a wafer, the attachment structure including a metal sheet and an insulating film attached to the metal sheet, according to some embodiments of the present disclosure;
FIG. 13 shows a schematic flowchart of a manufacturing method of the device according to some embodiments of the present disclosure;
FIG. 14 shows a schematic perspective view of a device according to some embodiments of the present disclosure and a device of a comparative example; and
FIG. 15 shows a schematic sectional view of a device according to some embodiments of the present disclosure.

Note that in the embodiments described below, the same reference numerals are sometimes used in different drawings to represent the same parts or the parts with the same functions, and their repetitive explanations will be omitted. In this specification, similar reference numerals and letters are employed to denote the similar items/elements , and therefore, once an item is defined in a drawing, further repetitive discussion thereof will be not required in the accompanying drawings.

For ease of understanding, the positions, dimensions, and ranges of the structures shown in the drawings may not necessarily represent the actual positions, dimensions, and ranges. Therefore, the present disclosure shall not be limited to the positions, dimensions, and ranges or the like disclosed in the accompanying drawings.

### Detailed Description

Various exemplary embodiments of the present disclosure will now be described in detail with reference to the accompanying drawings. Notice that unless otherwise specified, the relative arrangement, numerical expressions and values of the components and steps set forth in these examples are not intended to limit the scope of the present disclosure. Techniques, methods, and devices known to those of ordinary skills in the relevant art may not be discussed in detail, but where appropriate, these techniques, methods, and devices should be considered as parts of the specification.

The following description of at least one exemplary embodiment is merely illustrative and is not intended in any means to limit the present disclosure, its applications or uses. It should also be understood that any embodiment exemplarily described herein does not necessarily to be construed as preferred or advantageous over other embodiments. The present disclosure is not intended to be bound by any expressed or implied theory presented in the preceding technical field, the background, or the detailed description.

Additionally, a certain terminology may be used in the following description for reference purposes only, and therefore is not intended for limiting purpose. For example, unless explicitly stated by in the context, the terms "first", "second" and other such numerical terms referring to structures or elements do not imply a sequence or order.

It will also be understood that the word "comprises/comprising" when used herein, is intended to indicate that there is a stated feature, integer, step, operation, element, and/or component, but does not preclude the presence or addition of one or more other features, integers, steps, operations, elements, and/or components and/or a combination thereof.

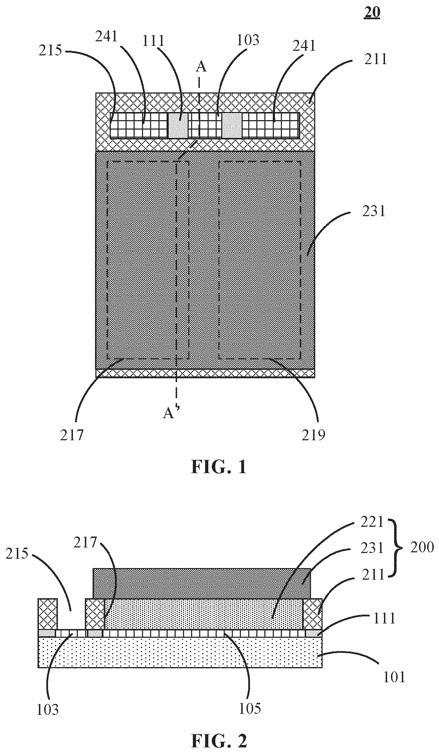

FIG. 1 shows a schematic top view of a device according to some embodiments of the present disclosure. FIG. 2 shows a schematic sectional view of the device along the A-A 'line shown in FIG. 1. As shown in FIGS. 1 and 2, the semiconductor apparatus 20 includes a semiconductor substrate 101 and an attachment structure 200 over the semiconductor substrate 101. As shown in the figures, the attachment structure 200 may include an insulating film 211, an attachment component 221, and a metal sheet 231.

The semiconductor substrate 101 may include at least one power semiconductor device (not labeled) . A conductive structure for external electrical connection, such as a metallization layer, may be formed on the semiconductor substrate or in a surface of the semiconductor substrate, it may be the topmost metallization layer over the semiconductor substrate and may include one or more portions 103 and 105, each of which may serve as a terminal (including pad or electrode) for a power semiconductor device. Although the surface of the substrate 101 is shown in the figures to be in substantially the same plane with the metallization portions 103 and 105 embedded in an insulating film (e.g., a passivation film) 111, it should be understood that the disclosure is not limited thereto.

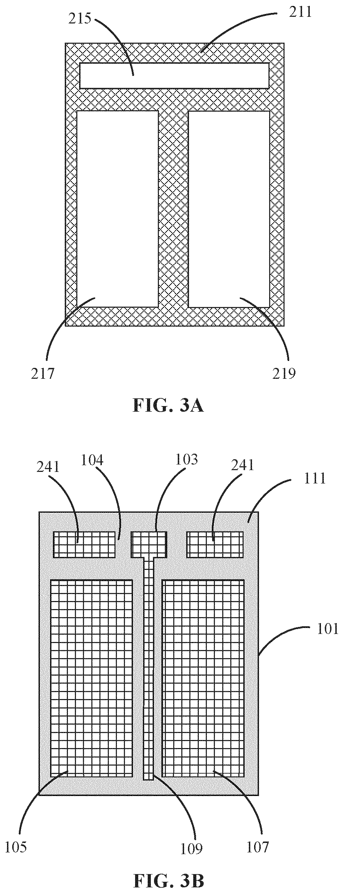

The insulating film 211 is disposed over the semiconductor substrate 101. Preferably, the insulating film 211 is formed of organic material such as, but not limited to, polyetherimide (PEI) or polyimide (PI). FIG. 3A shows a schematic top view of an insulating film of the device according to some embodiments of the present disclosure. The insulating film 211 has at least one first opening that penetrates through the insulating film; here two openings 217, 219 are shown in the figure. The openings 217 and 219 are illustrated in dashed boxes in FIG. 1. In some embodiments, the thickness of the insulating film may be in a range from 20 µm to 150 µm, such as 20um, 50um, 100µm, 150 µm.

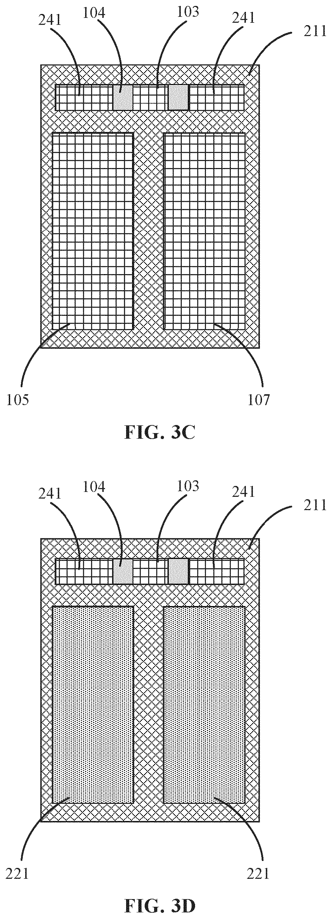

The at least one first opening 217, 219 exposes a corresponding first portion of the semiconductor substrate (e.g., see FIG. 3C). In some embodiments, the power semiconductor device may be a power metal-oxide-semiconductor (MOS) field-effect transistor (FET), and the openings 217, 219 may expose a current terminal (e.g., a source terminal) 105 (see FIG. 2) of the power MOS FET, for example. Although descriptions are presented here with use of a power MOSFET as an example, it should be understood that this disclosure is not limited thereto and can be applied to a variety of power devices. Furthermore, although the term "terminal" is used here in the descriptions, it should be understood that it may also include, or be, or may be substituted with, "electrode," "pad," "metallization layer," or the like.

As shown in FIG. 2, the conductive attachment component 221 is filled in a corresponding first opening (here, 217) of the at least one first opening. A metal sheet (also referred to as a metal foil) 231 is placed over the insulating film 211 and the at least one attachment component 221. In some embodiments, the metal sheet preferably completely covers the at least one attachment component 221 to provide reliable electrical and physical coupling. The attachment component 221 bonds (and thereby electrically couples) a corresponding portion of the metal sheet 231 to a corresponding first portion of the semiconductor substrate 101. The metal sheet may include one or more layers of metal or metal alloy material. In some embodiments, the metal sheet may include, for example but not limited to, copper (Cu), silver (Ag), gold (Au), aluminum (Al), alloys containing one or more of the above materials, or any other suitable metal material. In some embodiments, the metal sheet may also include an additional coating, which may include, but is not limited to, one or more of the following materials: silver, gold, nickel (Ni), alloys containing one or more of the above materials (e.g., Ni-Ag, Ni-Pd-Au, or Ni-Au), or any other suitable metal materials. In some embodiments, the thickness of the metal sheet may be in a range from, for example, 35 microns to 250 microns, such as 35 microns, 50 microns, 100 microns, 150 microns, 200 microns, or 250 microns.

In some embodiments, the attachment component is obtained by processing an attachment material. For example, the attachment material may include solder, sintering paste (e.g., silver sintering paste), pre-formed sintering sheet, or conductive adhesive (e.g., silver adhesive), etc.

For example, in the case of sintering paste, after the sintering paste is filled into the opening of the insulating film, a preheating (pre-drying) process may be performed; then, after the attachment structure including the preheated (pre-dried) sintering paste is applied to the substrate, a process of sintering, welding, curing, or the like is performed to bond the metal sheet 231 to the substrate (more specifically, to the metal layer (terminal) on the substrate).

For example, in the case of preformed sintering sheet, the bonding between the metal sheet 231 and the substrate can be achieved by directly performing a sintering process after applying the attachment structure including the sintering sheet to the substrate.

Transient liquid phase welding material (such as gold (Au) - tin (Sn) alloys or alloys containing one or more of nickel (Ni), tin (Sn), and copper (Cu), which may be in sheet or paste form) may also be used as the attachment material to achieve bonding between the metal sheet 231 and the substrate by a transient liquid phase welding process.

For example, in the case of solder, after the solder is dispersed into the opening(s) of the insulating film, the attachment structure is applied to the substrate; then a reflow soldering may be performed to bond the metal sheet 231 to the substrate. As another example, in the case of conductive adhesive, after the conductive adhesive is dispersed into the opening(s) of the insulating film, the attachment structure is applied to the substrate; then a heating or curing process may be performed to bond the metal sheet 231 to the substrate.

Preferably, the insulating film 211 is configured to provide a certain level of adhesive force by itself to firmly adhesive the substrate to the metal sheet, even in the absence of an attachment component or when a material used to form the attachment component requires further processing to provide a stable bond. For example, for the insulating film, materials that inherently have adhesive properties or have adhesive properties after being processed can be selected. In some embodiments, the insulating film 211 may be formed of organic materials such as polyetherimide (PEI) or polyimide (PI). However, the present disclosure is not limited to this. The insulating film may be heat treated to be, for example, in a semi-cured state, so that it has some a certain level of adhesion while maintaining its basic shape. The metal sheet may be attached (or applied) to the insulating film while the insulating film is in such semi-solid state. Similarly, the attachment structure may also be applied to the substrate (with the insulating film being in contact with the substrate) while the insulating film is in the semi-solid state. It should be understood that the above examples are merely illustrative and not limiting. For example, in other embodiments, an adhesive or co-adhesive may be applied to one or both sides of the insulating film to enhance its adhesion. In some embodiments, temporary adhesion or positioning support may be provided by adsorption effects of smooth surfaces, by hydrogen bonding or dangling bonds between surfaces, or by external holding devices. Therefore, there are no particular limitations on the material used to form the insulating film, as long as it may withstand the temperature in the processes and provide some certain level of adhesion.

In some embodiments, the insulating film 211 further includes at least one second penetrating-through opening 215 as shown in FIGS. 1 and 2. For example, the second opening 215 may expose a corresponding second portion of the semiconductor substrate. For example, the second opening 215 may expose a control terminal (e.g. a gate terminal) 103 of a power MOSFET. As shown in the figure, the metal sheet 231 is configured to not overlap with the second opening 215. In FIG. 1, the opening 215 also exposes another terminal 241 and the insulating layer 111 (e.g., a passivation layer) over the substrate.

In the examples shown in FIGS. 1 and 2, the semiconductor substrate is a die separated from a wafer (e.g. by cutting). In this case, the material of the insulating film and the material of the metal sheet are substantially not present on the lateral side faces of the semiconductor substrate. At least one side face of the insulating film, a corresponding side face of the metal sheet, and a corresponding side face of the semiconductor substrate are substantially flush with each other.

FIG. 3B shows a schematic top view of the substrate portion of the device according to some embodiments of the present disclosure. As shown in FIG. 3B, the substrate 101 includes an insulating layer 111 (e.g., a passivation layer formed of silicon dioxide or other insulating materials) at the upper portion of the substrate 101. The insulation layer 111 has openings that respectively expose terminals. Here, taking a MOSFET as an example, a gate terminal 103 and source terminals (or drain terminals) 105 and 107 are shown. Other auxiliary terminal(s) 241 is/are also shown, which may provide connection(s) to a back gate or a drift region, for example. In some embodiments, the gate terminal 103 may include a trench gate structure 109, as illustrated in FIG. 3B. It should be understood here that, depending on various implementations, the trench gate structure 109 may also be covered by the passivation layer 111.

FIG. 3C shows a schematic top view of a portion of the device according to some embodiments of the present disclosure. Here, the insulating film 211 shown in FIG. 3A is disposed on the substrate shown in FIG. 3B. In other words, the metal sheet 231 and attachment component 221 shown in FIGS. 1 and 2 have been removed. The openings 215, 217, and 219 in the insulating film 211 expose corresponding parts (including corresponding terminals) on the substrate.

FIG. 3D shows a schematic top view of a portion of the device according to some embodiments of the present disclosure. Here, based on FIG. 3C, an attachment component or attachment material 221 is formed in the first openings 217 and 219 of the insulating film 211. In other words, the metal sheet 231 of the device shown in FIGS. 1 and 2 has been removed.

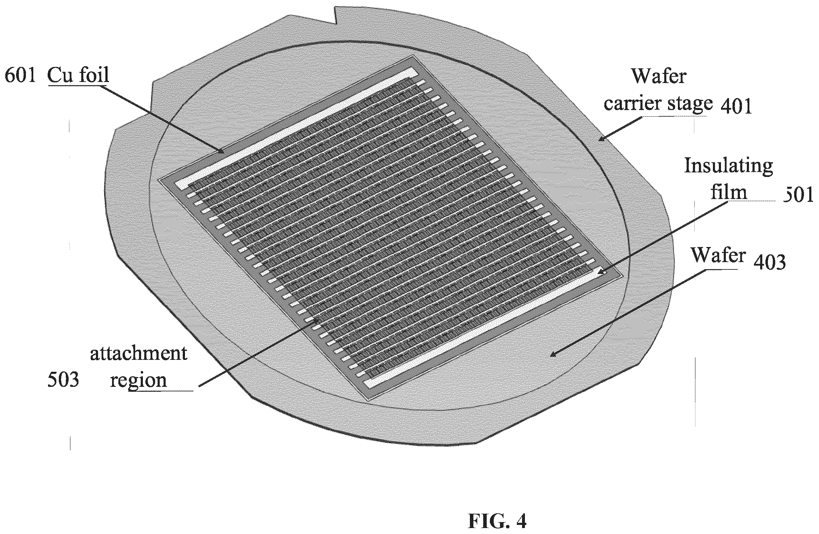

FIG. 4 shows a schematic perspective view of the device in a wafer-level manufacturing process according to some embodiments of the present disclosure. As shown in FIG. 4, a wafer 403 is loaded onto a wafer carrier stage (e.g., a carrier ring) 401. An attachment structure including an insulating film 501 and a metal sheet (e.g., a copper foil) attached to the insulating film 501, as well as an attachment material (not shown in FIG. 4) filled in the openings (attachment region) 503 of the insulating film 501 is attached (applied) to the wafer 403. The wafer 403 may include a plurality of power semiconductor devices arranged in an array.

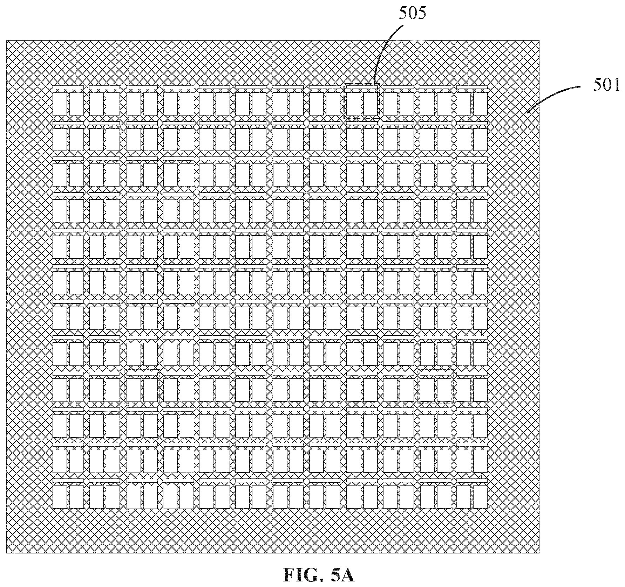

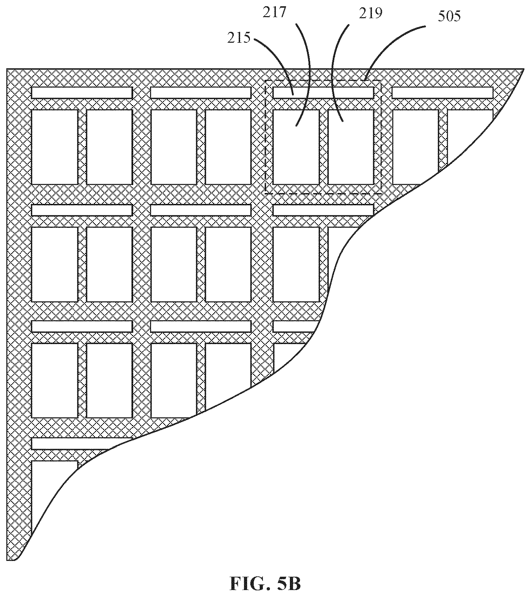

FIG. 5A shows a schematic top view of an insulating film according to some embodiments of the present disclosure, and FIG. 5B shows an enlarged view of a portion of the insulating film. As shown in FIG. 5A, the insulating film 501 includes multiple units 505. A unit 505 may be, for example, the insulating film 211 as shown in FIGS. 1 to 3A, and corresponds to a device of the plurality of power semiconductor devices. The aforementioned insulating film 211 for a die may be formed by cutting (as will be explained later) the insulating film 501. FIG. 5B shows an enlarged view of a portion of the insulating film 501. The terminals (e.g., metal layers) of corresponding semiconductor devices in the semiconductor substrate may be exposed through openings 215, 217, and 219 in the respective unit 505 of the insulating film.

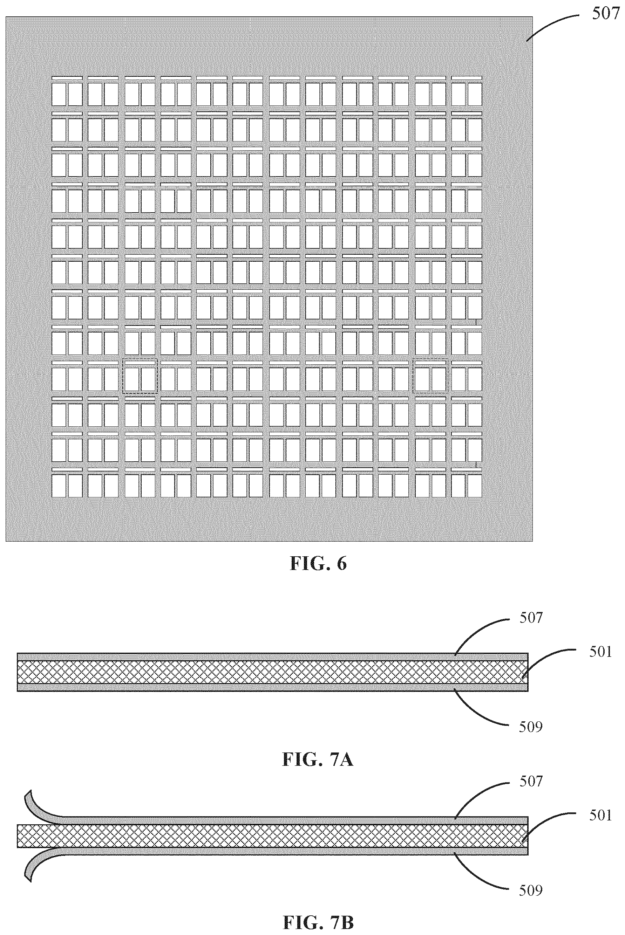

FIG. 6 shows a schematic top view of an insulating film according to some embodiments of the present disclosure. FIGS. 7A and 7B show schematic sectional views of the insulating film according to other embodiments of the present disclosure. In this example, additional coatings 507 and 509 are provided on the upper and lower surfaces of the insulating film 501. In some embodiments, the coatings 507 and 509 may be formed of materials different from the insulating film 501 and configured to be easily removed or peeled from the insulating film 501, as shown in FIG. 7B.

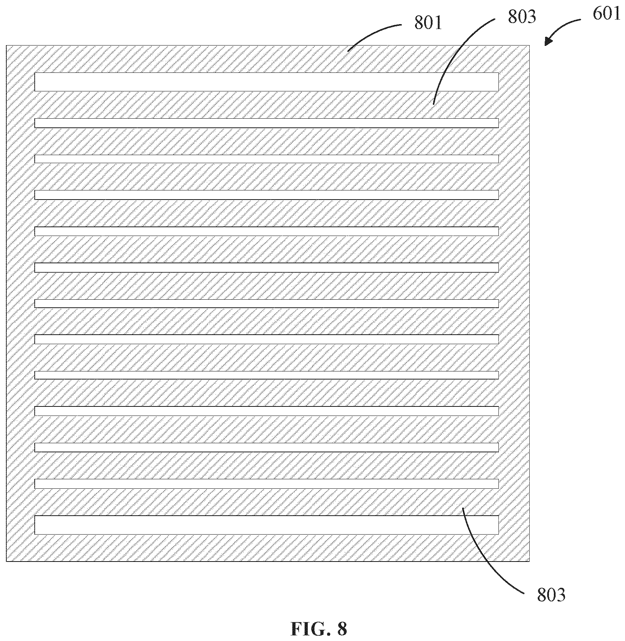

FIG. 8 shows a schematic top view of a metal sheet according to some embodiments of the present disclosure. In some embodiments, the metal sheet 601 may be formed of copper, for example, integrally formed of copper. The metal sheet 601 may include a peripheral frame 801 and a spanning structure 803 corresponding to the array of power devices (as well as the corresponding units of the insulating film 501).

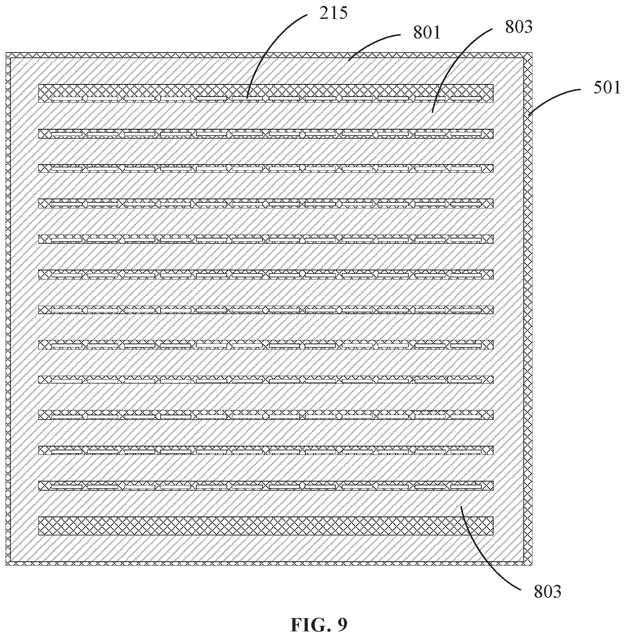

FIG. 9 shows a schematic top view of a metal sheet attached to an insulating film according to some embodiments of the present disclosure. In some embodiments, the coating 507 on one side of the insulating film 501 may be removed (as shown in FIG. 7B), and the metal sheet 601 may be attached to the insulating film 501 on that side, as shown in FIG. 9. In some embodiments, the metal sheet may be attached to the insulating film 501 by, for example, a pick and place device.

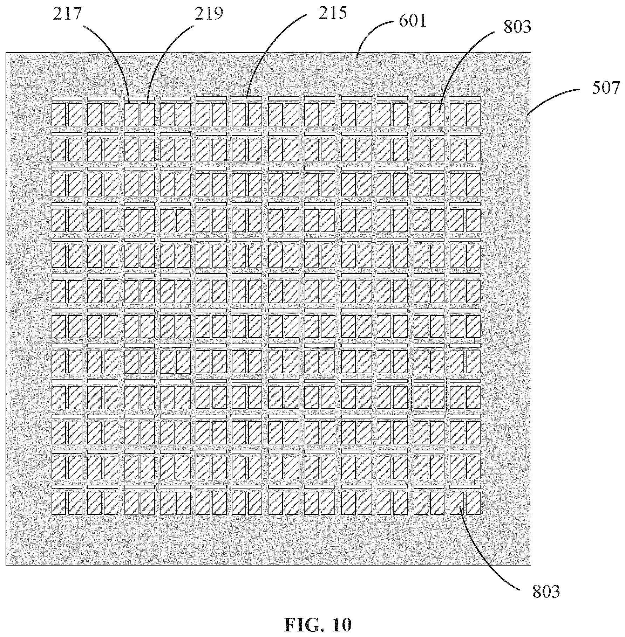

Here, the spanning structure 803 of the metal sheet 601 covers, or overlaps with, a corresponding row of units 505 of the insulating film 501, and does not overlap with openings 215 of that row of units, i.e., the openings 215 of that row of units are exposed. FIG. 10 shows a schematic top view of a metal sheet attached to an insulating film, viewed from a side of the insulating film away from the metal sheet, according to some embodiments of the present disclosure, i.e., a view from another side of the structure shown in FIG. 9 after being flipped. As shown in FIG. 10, the corresponding portions of the metal sheet 601 are exposed through the openings 217 and 219 of the units of the insulating film 501. Furthermore, in FIG. 10, the obscured portion of the metal sheet 601 under the insulating film is also shown in a semi-transparent manner. Here, in the example shown in FIG. 10, the coating 507 on this side of the insulating film 601 is not removed.

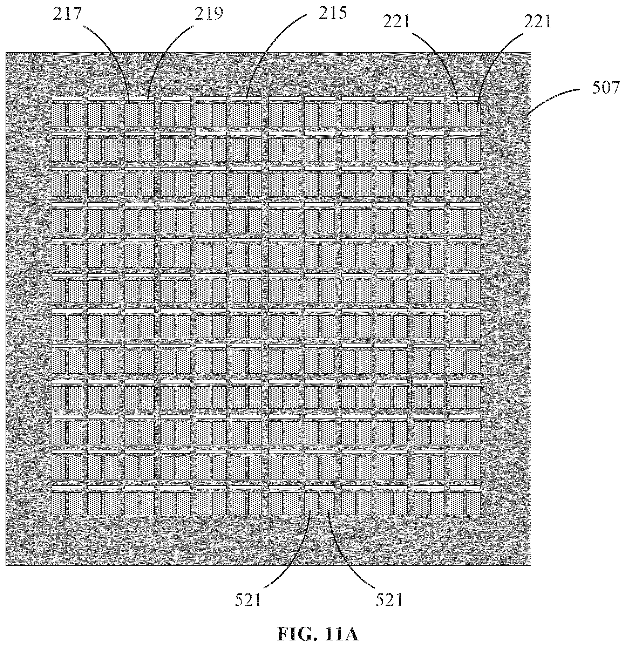

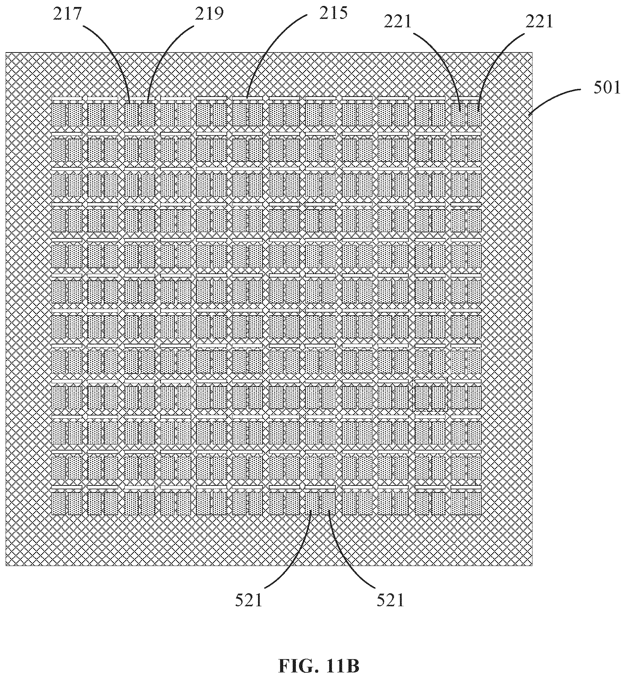

FIG. 11A shows a schematic top view of a metal sheet attached to an insulating film, viewed from a side of the insulating film away from the metal sheet, according to some embodiments of the present disclosure. As shown in FIG. 11A, based on the structure shown in FIG. 10, an attachment material 521 is applied from a side of the insulating film 501 opposite to the metal sheet 601 to fill the corresponding openings 217 and 219 to form attachment component(s) (e.g., attachment component(s) 221). The attachment material includes a conductive material. In some embodiments, a high-precision printing method may be used to print a sintering paste (also known as sintering slurry) into the corresponding openings, thereby reducing the probability of sintering paste overflow. A pre-formed sintering sheet may be applied, or a solder or a conductive adhesive may be applied into the openings 217 and 219 as an attachment material. Here, in the example shown in FIG. 11A, the coating 507 on this side of the insulating film 601 is not removed. Thereafter, in some embodiments, the coating 507 may be removed, as shown in FIG. 11B. In some other embodiments, the coating 507 may also be retained. If the coating 507 is retained, this coating is considered as a part of the insulating film.

Depending on the materials used for the attachment component, some optional processes may be applied to the attachment material. For example, a pre-process such as preheating, pre-drying, pre-sintering or semi-curing may be performed on the attachment material.

For example, in some cases, some plated coatings may also be applied on the substrate and/or metal sheet. In this case, these plated coatings may be considered as part of the substrate and/or metal sheet. For example, in the case that a thermal process is involved, naturally a cooling process may be also involved. In the present disclosure, in order not to obscure the essence of the present disclosure, some conventional processes or components may be not described in detail, but rather descriptions focus on those aspects, components, or processing techniques that are of concern to the present disclosure. Therefore, those skilled in the related art would readily understand that the disclosed aspects or embodiments do not exclude the presence of other processes or components not of concern to the present disclosure.

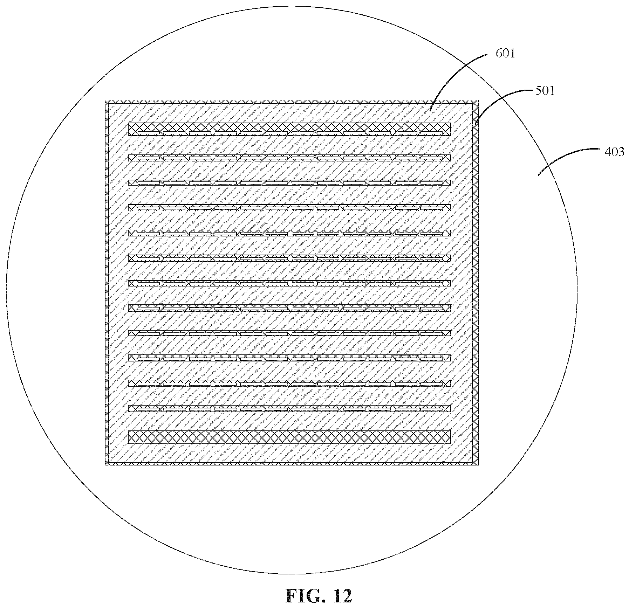

Then, the attachment structure including the insulating film, the metal sheet, and the applied attachment material is attached to the wafer. FIG. 12 shows a schematic top view of an attachment structure attached (applied) to a wafer according to some embodiments of the present disclosure. As shown in FIGS. 4 and 12, the attachment material 521 and a side of the insulating film opposite to the metal sheet 601 are attached to the wafer, so that the attachment component 521 and the insulating film are in contact with the wafer. As mentioned above, the insulating film 501 itself may have some level of adhesion to keep the metal sheet 601 in place with the wafer.

Then, depending on the different attachment materials and insulating film materials used, appropriate processes may be carried out, which herein are referred to as bonding process. For example, sintering or transient diffusion soldering, reflow soldering, baking annealing, or curing may be performed to firmly bond the metal sheet and the terminals (metal layers) on the wafer( and thus, the wafer) with the attachment material.

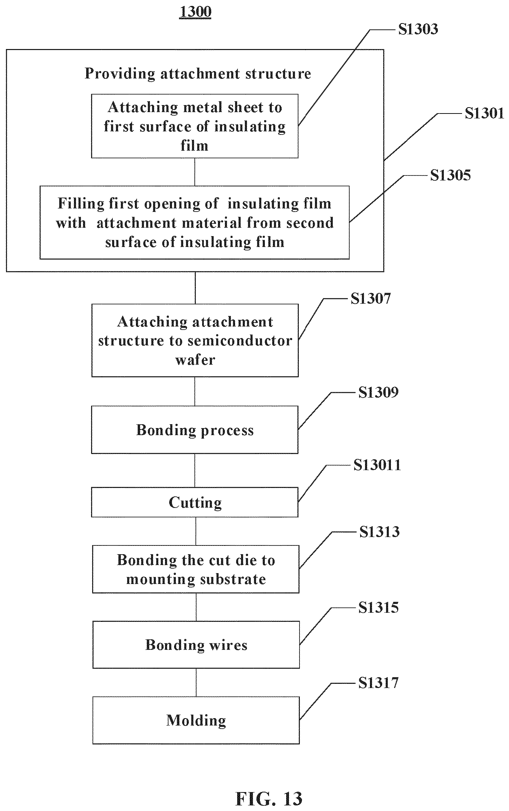

FIG. 13 shows a schematic flowchart of a manufacturing method 1300 of the device according to some embodiments of the present disclosure. As shown in FIG. 13, in step S1301, an attachment structure is provided. The attachment structure may be an attachment structure as described above. For example, the attachment structure may comprise an insulating film having at least one first opening penetrating through the insulating film, the at least one first opening corresponding to a corresponding first portion of a semiconductor substrate. The attachment structure further comprises a metal sheet attached to the insulating film, the metal sheet comprising a portion overlapping the at least one first opening of the insulating film. The attachment structure further comprises an attachment material filled in a corresponding first opening of the at least one first opening and in contact with the metal sheet. The attachment material includes a conductive material.

In some embodiments, providing an attachment structure may comprise: at step S1303, attaching the metal sheet to a first surface of the insulating film; and at step S1305, filling the at least one first opening of the insulating film with an attachment material from a second surface of the insulating film opposite to the first surface, the attachment material filled in the at least one first opening being in contact with the metal sheet.

The method further comprises, at step S1307, attaching the attachment structure to a semiconductor wafer. The semiconductor wafer comprises at least one power semiconductor device. This step brings the insulating film into contact with the semiconductor chip, wherein the at least one first opening corresponds to a corresponding first portion of the semiconductor substrate and the attachment material is in contact with the corresponding first portion of the semiconductor substrate.

In some embodiments, optionally, the method further comprises, at step S1309, performing a bonding process. In this process, an attachment component is formed from the attachment material to attach and electrically couple a corresponding portion of the metal sheet to a corresponding first portion of the semiconductor substrate through the attachment component. The bonding process may include at least one of sintering, baking, annealing, or curing. Thus, the attachment material filled in the insulating film may be cured, sintered, or melted, allowing the metal sheet to be attached to the semiconductor substrate (more precisely, to a metallization layer (including electrodes, terminals, pads, or the like) on the semiconductor substrate) through the attachment component. Although not described in detail here, those skilled in the art will readily understand that the attachment material having subjected to this bonding process may be cooled to room temperature.

Thereafter, at step S13011, cutting is performed to form a die, such as the device or die 20 shown in FIGS. 1 and 2. For example, the cutting step may be carried out by sawing or laser cutting. Note that the device or die 20 of the present disclosure includes a substrate and an attachment structure 200, namely the insulating film, the metal sheet, and the attachment component formed thereon.

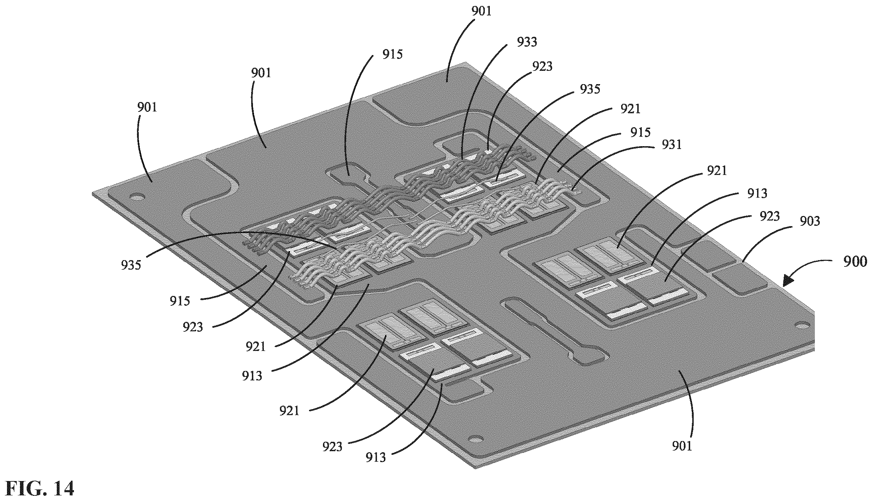

Then, at step S1313, the die obtained through cutting is bonded to a mounting substrate. For example, the die obtained through cutting may be picked up and placed on a mounting substrate (on which an attachment material such as a sintering paste may be formed). Then, a bonding process (such as, sintering) is carried out to bond the die to the mounting substrate. At step S1315, corresponding wires are coupled to the metal sheet and the exposed terminals (such as, a gate terminal 103 or other terminals 241), as shown in FIG. 14.

Then, at step S1317, a molding process may be performed to encapsulate the die, at least a portion of the mounting substrate, and the wires with a molding compound.

FIG. 14 shows a schematic perspective view of a device according to some embodiments of the present disclosure and a device of a comparative example. FIG. 14 shows a die 921 of the prior art and a device (die) 923 manufactured according to an embodiment of the present disclosure.

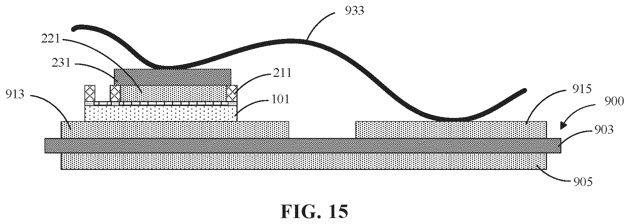

Both the dies 921 and 923 are mounted on a mounting substrate 900. The substrate 900 may have an insulating layer 903 and metal layers 901 and 905 on both sides of the insulating layer. The bottom terminals (metallization layers) of both dies 921 and 923 are bonded and electrically coupled to a die attachment portion 913 in the metal layer 901 over the substrate 900. FIG. 15 shows a schematic sectional view of a device 923 mounted on a mounting substrate and bonded with wires 933 according to some embodiments of the present disclosure.

For the die 921 of the prior art, aluminum wires 931 are attached to its current terminal (e.g. the source). For the die 923 of the present disclosure, larger diameter copper wires 933 may be used to bond the metal sheet (e.g., metal sheet 231) of the die 923 to the leads 915.

Because the metallization layer (such as electrodes, terminals, or pads) formed on the semiconductor substrate in the die 921 of the prior art often has a thin thickness, such as a thickness of a few micrometers (e.g., 2 µm), it may not be able to withstand a copper wire bonding process, which may result in defects. According to the embodiments of the present disclosure, the metal sheet is attached to the die via the insulating film and the attachment component, and the wires are attached to the metal sheet over the die. Thus, wires with larger diameter or larger hardness (such as copper wires) may be used, thereby improving the performance and reliability of the device. In addition, because of the presence of the insulating layers 211 and 501, the impact of the copper wire bonding process on the die can be reduced, which may further improve reliability. It should also be noted that although individual wires are shown as an example in the example illustrated, the present disclosure is not limited thereto. For example, in the context of this disclosure, the term "wire" also encompasses various forms, including individual wire and wire strip containing multiple wires arranged side by side.

According to one aspect of this disclosure, there is further provided an electrical system that comprises any semiconductor apparatus as disclosed herein or obviously derived from the present disclosure.

According to an embodiment of the present disclosure, a novel wafer-level Die Top System (DTS) package and its manufacturing method are provided. According to the estimation by the inventors, the embodiments of the present disclosure may reduce the time of the manufacturing process thereof to about one-third to one-fourth as compared to the existing DTS scheme, thereby greatly improving manufacturing efficiency.

In addition, according to embodiments of the present disclosure, by providing the insulating film, the distance and electrical isolation between the metal sheet and the semiconductor substrate are increased and the dielectric strength is increased, thereby preventing unwanted discharge or creepage between the substrate and the metal sheet connected to the source.

By providing the insulating film, adhesion may also be provided to maintain the die and the metal sheet (such as Cu foil) in place prior to a stable attachment is provided between the die and the metal sheet with the attachment component (or attachment material), thereby reducing or eliminating relative displacement between the die and the metal sheet and simplifying the process.

According to aspects and embodiments of the present disclosure, device processability and UPH may be improved. It also eliminates the need for harsh storage conditions, significantly reducing shipping costs.

In addition, with the insulating film, mechanical strength can be improved, and deformation of the attachment material prior to sintering/reflow can be prevented.

In addition, by providing the insulating film, various stresses or strains during manufacturing processes (such as heat treatment, pressure bonding, or wire welding), such as warping, deformation, or other strains caused by differences in coefficient of thermal expansion (CTE) or external pressure, may be absorbed or mitigated.

According to the embodiments of the present disclosure, the use of tacking agent can be prevented, thereby avoiding the problem of voids in the prior art and increasing the reliability and life of the device.

According to the embodiments of the present disclosure, by using an insulating film and filling the attachment component (or attachment material) in the opening of the insulating film, the thickness of the attachment material can be increased and attachment reliability can be improved.

Although embodiments are described using a power MOSFET as an example, those skilled in the art will readily understand that this disclosure shall not be limited thereto, instead may be applied to a variety of power devices, such as but not limited to, thyristors and power diodes, to which the principles and teachings of this disclosure may be applied so long as they have electrodes or terminals that need to withstand high currents and/or voltages.

Those skilled in the art will appreciate that the boundaries between the above-described operations (or steps) are merely illustrative. Multiple operations may be combined into a single operation, a single operation may be distributed in additional operations, and the operations may be carried out at least partially overlapping in time. Moreover, alternative embodiments may include multiple instances of a particular operation, and the order of operations may be altered in other embodiments. However, other modifications, changes and substitutions are also possible. Accordingly, the specification and drawings are illustrative rather than restrictive.

Although some specific embodiments of the present disclosure have been described in detail by way of example, those skilled in the art should understand that the above examples are only for the purpose of illustration and are not intended to limit the scope of the present disclosure. The various embodiments disclosed herein may be combined arbitrarily without departing from the spirit and scope of the present disclosure. Those skilled in the art should also understand that modifications may be made to the embodiments without departing from the scope and spirit of the present disclosure. The scope of the present disclosure is defined by the following claims.

## Claims

1. A semiconductor apparatus, comprising:
a semiconductor substrate comprising at least one power semiconductor device;
an insulating film on the semiconductor substrate, the insulating film having at least one first opening that penetrates through the insulating film, the at least one first opening exposing a corresponding first portion of the semiconductor substrate;
at least one conductive attachment component filled in a corresponding first opening of the at least one first opening; and
a metal sheet provided on the insulating film and the at least one attachment component; and
wherein a corresponding portion of the metal sheet is bonded and electrically connected to the corresponding first portion of the semiconductor substrate by the at least one attachment component.

2. The semiconductor apparatus of claim 1, wherein the insulating film further comprises at least one second opening that exposes a corresponding second portion of the semiconductor substrate; and
wherein the metal sheet does not overlap with the at least one second opening.

3. The semiconductor apparatus of claim 2, wherein the at least one first opening exposes at least a portion of a corresponding current terminal of a corresponding semiconductor device, and the at least one second opening exposes at least a portion of a control terminal of the corresponding semiconductor device.

4. The semiconductor apparatus of claim 1, wherein the semiconductor substrate comprises a wafer;
wherein the at least one power semiconductor device comprises a plurality of power semiconductor devices arranged in an array; and
wherein the insulating film comprises a plurality of first openings each exposing a metallization layer of a corresponding one of the plurality of power semiconductor devices.

5. The semiconductor apparatus of claim 1, wherein the semiconductor substrate comprises a die separated from a wafer; and
wherein the insulating film and the metal sheet are substantially not present on lateral side faces of the semiconductor substrate; and
wherein at least one side face of the insulating film, a corresponding side face of the metal sheet and a corresponding side face of the semiconductor substrate are substantially flush with each other.

6. The semiconductor apparatus of claim 1, wherein the insulating film is formed of an organic material; and
wherein the metal sheet comprises one or more layers of metal material.

7. The semiconductor apparatus of claim 1, wherein the attachment component is obtained by performing a bonding process on an applied attachment material, the bonding process comprising at least one of the following:
sintering, baking, annealing, transient liquid phase welding, or curing.

8. The semiconductor apparatus of claim 7, wherein the attachment material comprises one of the following:
a sintering paste, a pre-sintering sheet, a solder, a transient liquid phase soldering material, or a conductive adhesive.

9. The semiconductor apparatus of claim 3, wherein the at least one power semiconductor device is a power MOS transistor, the at least one first opening exposing at least a portion of a corresponding source or drain terminal of the corresponding semiconductor device, respectively, and the at least one second opening exposing at least a portion of a gate terminal of the corresponding semiconductor device.

10. The semiconductor apparatus of claim 3, further comprising:
at least one first wire coupled to a corresponding current terminal of the corresponding semiconductor device; and
at least one second wire coupled to a corresponding control terminal of the corresponding semiconductor device.

11. The semiconductor apparatus of claim 10, further comprising:
a mounting substrate comprising a die attachment portion and a lead;
wherein the semiconductor substrate is attached to the die attachment portion;
the at least one first wire is coupled to the lead; and
the at least one first wire comprising a copper wire.

12. An electrical system comprising the semiconductor apparatus of claim 1.

13. A method for manufacturing a semiconductor apparatus, comprising:
providing an attachment structure comprising:
an insulating film having at least one first opening penetrating through the insulating film, the at least one first opening exposing a corresponding first portion of a semiconductor substrate;
a metal sheet attached to the insulating film, the metal sheet comprising a portion overlapping with the at least one first opening of the insulating film; and
an attachment material filled in a corresponding first opening of the at least one first opening and in contact with the metal sheet, the attachment material comprising a conductive material;
attaching the attachment structure to a semiconductor wafer including at least one semiconductor device, such that the insulating film is in contact with the semiconductor wafer, the at least one first opening is aligned with a corresponding first portion of the semiconductor substrate, and the attachment material is in contact with the corresponding first portion of the semiconductor substrate; and
performing a bonding process to form an attachment component from the attachment material to bond and electrically couple a corresponding portion of the metal sheet to a corresponding first portion of the semiconductor substrate through the attachment component.

14. The method of claim 13, wherein providing an attachment structure comprises:
attaching the metal sheet to a first surface of the insulating film; and
filling the at least one first opening of the insulating film with the attachment material from a side of a second surface opposite to the first surface of the insulating film, the attachment material filled in the at least one first opening being in contact with the metal sheet.

15. The method of claim 13, further comprising:
conducting a cutting process, after the bonding process is performed, to form a separated semiconductor device.

16. The method of claim 13, wherein the insulating film further comprises at least one second opening that exposes a corresponding second portion of the semiconductor substrate; and
wherein the metal sheet does not overlap with the at least one second opening.

17. The method of claim 15, wherein the insulating film and the metal sheet are substantially not present on lateral side faces of the semiconductor substrate of the separated semiconductor device, and
wherein at least one side face of a portion of the insulating film included in the separated semiconductor device, a corresponding side face of a portion of the metal sheet included in the separated semiconductor device and a corresponding side face of the semiconductor substrate included in the separated semiconductor device are substantially flush with each other.

18. The method of claim 16, wherein the at least one semiconductor device comprises a power semiconductor device, the at least one first opening exposing at least a portion of a corresponding current terminal of a corresponding semiconductor device, and the at least one second opening exposing at least a portion of a control terminal of the corresponding semiconductor device.

19. The method of claim 13, wherein the insulating film is formed of organic material; and
wherein the metal sheet comprises one or more layers of metal material.

20. The method of claim 13, wherein the bonding process comprises at least one of sintering, baking, annealing, transient liquid phase welding, and/or curing.
